Europäisches Patentamt

European Patent Office

Office européen des brevets

(11) Publication number: **0 211 180**
**A2**

## (12) EUROPEAN PATENT APPLICATION

(21) Application number: 86107744.4

(51) Int. Cl.⁴: **H 05 K 3/46**

(22) Date of filing: 06.06.86

(30) Priority: 02.08.85 US 761843

(43) Date of publication of application:
25.02.87 Bulletin 87/9

(84) Designated Contracting States:
DE FR GB IT

(71) Applicant: SHIPLEY COMPANY INC.
2300 Washington Street
Newton, Massachusetts 02162(US)

(72) Inventor: Shipley, Charles R., Jr.
71 Vista Avenue
Newton, Mass. 02166(US)

(74) Representative: Leiser, Gottfried, Dipl.-Ing. et al,
Patentanwälte Prinz, Leiser, Bunke & Partner
Manzingerweg 7
D-8000 München 60(DE)

(54) Method for manufacture of multilayer circuit board.

(57) The invention is for the formation of multilayer circuit boards where layers are formed sequentially using selective plating techniques and photoimaging of permanent dielectric materials to achieve fine line resolution and interconnections between circuits. The invention permits the sequential formation of multilayers of higher density using photoimaging techniques.

FIG. 7

## METHOD FOR MANUFACTURE OF MULTILAYER
## CIRCUIT BOARD

### Background of the Invention

1.  Introduction

This invention relates to methods for the manufacture of multilayer circuit boards by sequential formation of layers having signal layers separated from each other by layers containing conductive interconnections.

2.  Description of the Prior Art.

Multilayer circuit fabrication is a means for providing multiple circuits in minimal volume. Multilayer boards typically comprise a stack of layers with signal lines (conductors) separated by a power and/or ground plane layer with the signal lines on one layer connected to the signal lines of another layer by plated holes known as "buried vias". The several layers are frequently bonded together with a pre-preg of a B-stage resin impregnated into a glass cloth fabric.

Current processes for fabricating multilayered boards comprise fabrication of separate innerlayers composed of circuit patterns with numerous conductors. A photosensitive material is coated over the copper surfaces of a copper clad innerlayer material, imaged, developed and etched to form a conductor pattern in the copper cladding protected by the photosensitive coating. After etching, the photosensitive

- 1 -

coating is stripped from the copper leaving the circuit pattern on the surface of the base material. A multilayer stack is then formed by preparing a lay-up of innerlayers comprising signal layers, ground plane layers, power plane layers, etc., typically separated from each other by a pre-preg which is a layer consisting of glass cloth impregnated with partially cured material, typically a B-stage epoxy resin. The outer layers of the stack (those on the top and bottom of the stack) often comprise copper clad glass filled epoxy board material with the copper cladding comprising the exterior surfaces of the stack. The stack is laminated to form a monolithic structure using heat and pressure to fully cure the B-stage resin.

Interconnects or through-holes, buried vias and blind hole interconnects are used to connect circuit layers within the multilayer board. Regardless of the form of interconnection, holes are generally drilled at appropriate locations through the stack. The holes are catalyzed by contact of the multilayer structure with a plating catalyst and the hole walls are metalized, typically with electroless copper overplated with electrolytic copper, to provide electrical contact between circuit innerlayers.

Multilayer boards have become increasingly complex. For example, the boards used for main frame computers may have as many as 36 layers of circuitry, with the complete stack having a

- 2 -

thickness of about 1/4 inch. These complex boards are currently designed with 4 mil wide signal lines and 12 mil diameter vias for interconnecting signal line layers. For increased densification of a board, it would be desirable to reduce signal lines to a width of 2 mils or less and vias to a diameter of 2 to 5 mils or less.

Summary of the Invention

To better understand the description which follows, the following definitions have been adopted:

"Permanent photo dielectric coating" means a dielectric coating composition that is radiation sensitive and developable to yield a relief image, which dielectric coating becomes an integral part of the multilayer board, and which is used to define openings for conductive interconnections between circuit or signal layers.

"Permanent photo mask" has the same meaning as permanent photo dielectric coating except that the mask is used to define openings and channels for conductive signal lines and interconnections within a circuit or signal layer. The permanent dielectric coating and the permanent photo mask may be same or different materials.

Both the permanent photo mask and the permanent photo dielectric coating may be applied as a liquid coating composition or as a dry film and preferably has a dielectric constant not exceeding 4.5.

- 3 -

"Photoformed openings" mean a relief image of channels defining conductors and/or openings defining interconnections within a permanent photo dielectric coating or a permanent photo mask. The channels and openings are used to contain metal selectively deposited into the relief image to render the same electrically conductive.

The subject invention provides a simplified process for the manufacture of high density multilayer circuit boards. The process comprises the sequential formation of layers comprising a multilayer circuit structure where the multilayer structure has at least two circuit layers with conductive interconnections between circuit layers.

The multilayer circuit structure is desirably formed over a temporary or permanent carrier that may become an integral part of the multilayer stack. For example, the carrier may be a circuit board substrate. If the carrier is a circuit, the process may comprise formation of a permanent photo dielectric coating over the circuit having a relief image of photoformed openings that define interconnections. The photoformed image is obtained by exposure of the photo dielectric coating to activating radiation in an image pattern and development to form the relief image. The photo dielectric coating may be coated with a photo mask in a photoformed pattern of conductors and interconnections where the openings define desired circuit

- 4 -

geometry such as conductors and interconnections. Metal is selectively deposited within the relief image to render the same conductive. The walls of the photo dielectric and photo mask coatings contain the metal as it deposits and assures the desired geometry or cross sectional shape of the same. The process is repeated sequentially as many times as desired to form sequential layers of circuits and interconnections until a desired number of layers are formed. Alternatively, one section may be formed as described and this stack may then be stacked with other stacks formed by the same or different processes to form the multilayer composite. The composite would then be laminated with heat and pressure to form the multilayer board. For purposes of this invention, the stacks may first be coated with a liquid resin and the liquid resin partially cured prior to lay-up. In this way, any crevices are filled with the liquid resin and air entrapment is eliminated.

If the carrier is other than a circuit, the process described above is modified as necessary. For example, the carrier might be a treated stainless steel platen. If so, a photo mask may be deposited on the platen and the circuit electroplated into the openings within the photo mask. This circuit would be the first circuit of the multilayer stack. A layer of interconnections through a permanent photo dielectric coating could then be formed over the circuit and the process

- 5 -

repeated until the desired number of layers of interconnections and circuits are sequentially formed to form the multilayer stack. At the conclusion of the process, or at any point when the stack is of sufficient strength, the platen may be removed.

In a process of the type contemplated herein, it should be understood that not all layers of a multilayer circuit are in electrical communication with each other. For example, an electrically isolated ground or power plane may comprise several of the layers in the multilayer stack with interconnections passing through the plane electrically isolated therefrom.

The use of a carrier, a photo dielectric and photo mask that become a permanent part of the circuit, photoforming, selective metal deposition, sequential formation of layers and permanent or temporary carriers characterize the invention.

Selective metal deposition in accordance with the invention may be performed in conventional manner or by new techniques to be described in greater detail below. Many of the procedures employed for selective metal deposition utilize a plating catalyst.

To obtain a relief image in the photo dielectric and/or photo mask coatings, the coating is exposed to activating radiation in an image pattern and developed to yield the pattern of photoformed openings and lines. The resolution of the openings is dependent upon the photo properties of the coating

- 6 -

materials used and upon the light source collimation. Such materials may be capable of development to yield high resolution relief images including openings that are smaller than the thickness of the coating. By use of such coatings, openings for interconnects and conductors can be imaged to a size equivalent to the resolution capability of the photo dielectric and photo mask in any shape desired. With high resolution materials, the conductors and openings can be reduced to less than 1 mil in width and can be reduced down to a few microns in width if desired.

Sequential formation of layers in part characterizes the invention. However, it should be realized that several stacks can be made by the sequential formation of layers. Two or more stacks formed in this manner may be laminated to each other to form a composite multilayer board. The stacks may be laminated together using a B-stage pre-preg of an epoxy impregnated into glass fabric. More preferably, the stacks are laminated together starting with an uncured, liquid resin rather than a pre-preg. The liquid resin fills any existing crevices within the stacks whereby air entrapment is avoided. Following coating with the liquid resin, the liquid coating is partially cured for handling purposes and the stacks are layed up and laminated. In addition to the above, a stack formed sequentially following the process of the invention may be laminated to a stack formed by a

- 7 -

prior art procedure, using either the pre-preg or the uncured liquid resin. Consequently, multilayer boards can be formed though a combination of processes including integration of processes from the prior art and the process of this invention.

Description of the Drawings

In the drawings:

Figures 1 through 3 depict the cross section of a multilayer circuit formed over a copper clad innerlayer material at various stages during its fabrication;

Figures 4 through 7 depict the cross section of a multilayer board having signal and interconnect planes formed over an innerlayer material having a ground and power plane during various stages of its fabrication;

Figure 8 illustrates a lay-up for the formation of a multilayer board using the multilayer formed by the process depicted in Figures 4 through 7;

Figures 9 through 12 depict the formation of a layer using a sacrificial layer for selective catalysis;

Figures 13 to 17 represent a cross-section of a multilayer array formed using electroforming procedures over a temporary platen during various stages of its fabrication;

Figure 18 comprises a circuit on one surface of a substrate and a multilayered metal deposit on the other surface where the combination as described may consist of a housing for an electrical component having a circuit on one surface and EMI shielding on the other surface;

Figure 19 depicts a multilayer module formed in accordance with one embodiment of the invention; and

Figure 20 represents one embodiment of an interconnection formed using a photoformed opening in accordance with the invention.

Description of the Preferred Embodiments

The multilayer circuit, in accordance with the invention, is desirably formed over a carrier which may, if desired, become a part of the finished multilayer structure. The carrier may be permanent or temporary. A permanent carrier may comprise any of a number of different structures. For example, the carrier may be a conventional printed circuit board, a molded circuit, a hybrid circuit, ceramic, a housing for an item of electronic equipment, etc., each having a circuit thereon whereby additional layers may be added to the circuit. Another carrier may be an unclad plastic whereby multiple additive circuits may be sequentially built into a stack of circuits. A further embodiment of a permanent carrier may comprise a power and/or ground plane onto which multiple circuit layers may be formed. A temporary carrier may comprise a platen onto which multiple layers can be sequentially applied after which the multilayer stack can be separated from the platen. If the platen is a

- 9 -

conductor such as a stainless steel platen, at least the first circuit layer may be formed using electroforming techniques whereby the imaged dielectric layer is formed on the platen and metal is electrolytically deposited onto the exposed portions of the platen. For manufacturing efficiency, circuits are desirably formed on both sides of the platen.

The method of forming the circuitry on the carrier is not critical to the invention. For example, the circuit can be formed using conventional print and etch methods whereby the circuit is formed by etching copper cladding masked by an etch resistant coating. Alternatively, the circuit can be formed additively or semi-additively by methods known to the art. Other methods for forming circuitry on a substrate known to the art include electroforming, conductive pastes and inks, etc. and do not constitute a part of this invention.

The process of the invention uses selective plating techniques. Selective plating techniques are not considered a part of the invention though the manner of using the selective plating techniques to form circuits in accordance with the description that follows is considered to be a part of the invention.

There are methods known in the art for selective plating. Selective plating can be accomplished using masks applied over catalyzed substrates, differential adsorption of a plating

- 10 -

catalyst followed by stripping as exemplified in U.S. Patent No. 3,562,038, sacrificial layers (believed to be novel method for selective plating), photo dielectric catalyzed layers, selective application of catalytic poisons, activation of copper surfaces with palladium solutions, photosensitive catalysis, etc.

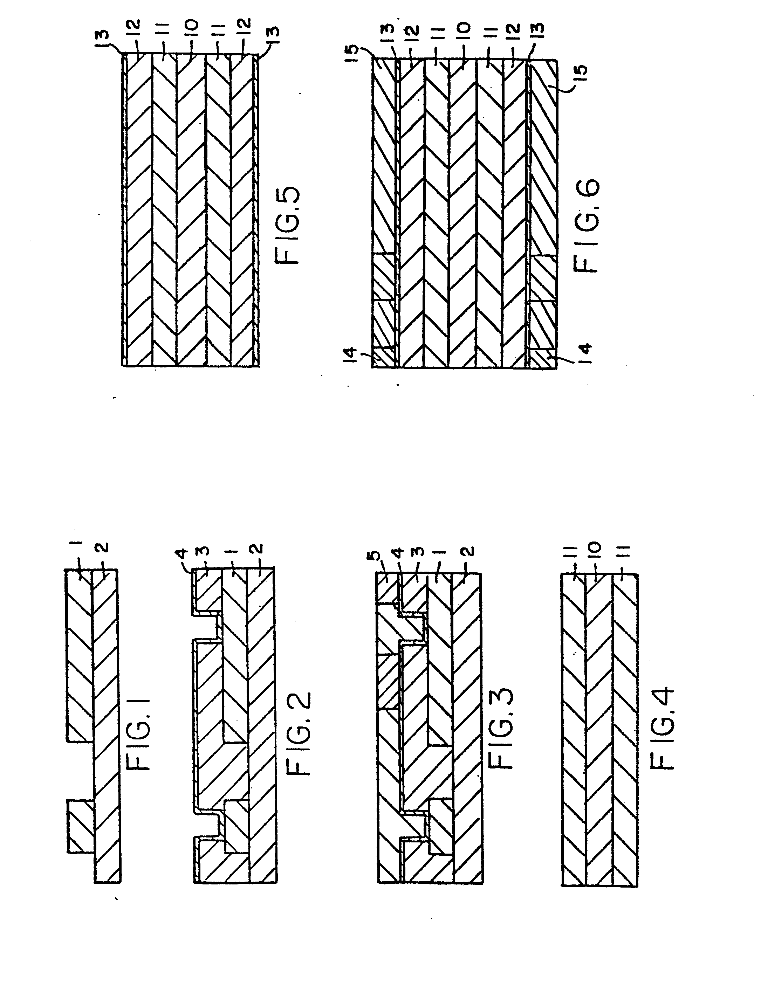

Figures 1 through 3 of the drawings represent the formation of a multilayered stack comprising sequentially applied layers over a permanent carrier. In this embodiment of the invention, beginning with Figure 1, the first step utilizes a conventional copper clad innerlayer material as a permanent carrier. The innerlayer material, as represented in Figure 1 has been etched to form signal lines 1 over substrate 2.

In Figure 2, a layer of photo dielectric 3, imaged to provide a relief image of photoformed interconnects between the signal lines 3 and a next subsequent layer (not shown), is coated over the composite. Plating catalyst 4 is then applied over the dielectric layer 3 to catalyze the surface for subsequent selective metal plating.

The next steps in the process are shown in Figure 3 and comprise application of photo mask 5 in an image pattern of signal lines, vias, holes, etc. A photo mask is preferred for fine line imaging. The photo mask coats the catalyzed surface of dielectric layer 3 where plating is not desired. Copper conductors 6 are plated over the plating catalyst 4 not coated

- 11 -

0211180

with the mask as illustrated, preferably within the thickness of the photo mask as shown, most preferably to a thickness that provides a nearly planar surface. At this point in the process, there is provided a complete circuit having a circuit pattern and interconnects. The procedure described above can be repeated as often as desired to form a stack of multiple circuits. Alternatively, the stack so formed can be laminated to other stacks formed by same or a different procedure using a suitable material to adhere the stacks together.

The material used to adhere stacks together in accordance with the invention may be a conventional pre-preg. However, in accordance with a preferred embodiment of the invention, a liquid adhering agent is preferably applied over the stack and partially cured. In this way, the liquid penetrates any crevices that might be present on the surface of the stack whereby entrapped air pockets are eliminated. Following application of the adhering agent, for ease of handling, the adhering agent is preferably partially cured to a relatively dry state. The liquid adhering agent may be a resin of the type used in such processes prior to cure such as an uncured epoxy resin.

In the above process, the photo dielectric and photo mask layers are applied in art recognized manner. For example, they may be applied as a liquid coating composition and dried or as a

- 12 -

dry film.  If in the form of a dry film, the film may be a single layer film or may comprise multiple layers.

As is known in the art, contact of the plating solution with the plating catalyst results in autocatalytic deposition of electroless metal over the exposed plating catalyst.  Plating continues until the structure is removed from the plating solution.  The plating solution used is typically an electroless copper solution. A suitable solution is Cuposit$^R$-251 electroless copper, a commercially available electroless copper plating solution available from Shipley Company Inc. of Newton, Massachusetts. A prefered solution is one capable of plating ductile copper able to withstand a solder shock test of about $260^O$C. for 10 seconds without cracking.  Plating is continued until the desired deposit thickness is achieved.

The process has been described in terms of electroless copper deposition.  It should be recognized that other metals may be used or multiple layers of metals.  For example, immersion tin or solder is often plated over a copper conductor.

In the above process, since the photo dielectric and photo mask define openings and channels into which metal deposits, the copper conductors and interconnects conform to the shape of the channel or opening.  Though the substrate has catalyst adsorbed onto its entire surface, metal deposition is selective to the bared catalyst in the channels.  If a high resolution photo mask

- 13 -

or photo dielectric has been used to define the image pattern, the metal conductors will have a cross-section conforming to the channel into which it has been plated, typically square or rectangular. Consequently, there is better control over the impedance of the conductor.

The insulative innerlayer substrate material used in the prior art for the fabrication of multilayer boards is typically reinforced plastic having a thickness of approximately 4 to 8 mils to which copper metal has been clad on each of its surfaces. In the prior art, when a copper coating is etched to define the circuit on the innerlayer, the metal cladding between the conductors is removed and the thickness of the innerlayer material where the cladding has been removed may be as thin as 4 mils. Since the lamination of the copper cladding has been performed at a high temperature, typically above 150$^{o}$C, the etching of the copper results in discontinuous circuitry, thereby relieving the plastic so that it can expand to its normal size at ambient temperature. Thus the coefficient of expansion differential between copper and plastic results in undesirable dimensional changes. Also, the very thin plastic substrate is subject to stretching or other distortion risks.

In contrast to the above, the spaces and conductors of the circuits formed in accordance with this invention, are imaged on substrates that are desirably dimensionally stable.

- 14 -

Furthermore, the spacings between conductor lines are filled with dielectric material, thereby affording somewhat improved dimensional stability. Unlike the above, the use of a power plane/ground plane innerlayer substrate provides good dimensional stability even though the plastic substrate may be thin, because the copper pattern is continuous and does not relieve the plastic, thereby eliminating dimensional change after etching. Therefore, the layers have improved dimensional stability.

The openings for interconnections between layers are photoformed and not drilled. In accordance with this invention, it is possible to form a multilayer board without drilling. In this respect, all vias can be formed by photoforming and selective deposition though it may be desirable to drill holes from the exterior of the stack to its interior.

Figures 4 through 7 represent the fabrication of a multilayer board using procedures for formation of sequential layers similar to those depicted in Figures 1 through 3. However, in this embodiment, a copper clad innerlayer material is used as a carrier comprising innerlayer substrate 10 and copper cladding 11 on both of its surfaces. In this embodiment of the invention, the copper is used as a power/ground plane combination and consequently, is a continuous layer providing structural integrity to the innerlayer material. To

- 15 -

electrically isolate the power and ground planes, a dielectric layer 12 is coated over the ground and power planes 11.

In Figure 5, the composite has been immersed in an electroless plating catalyst to provide catalytic layer 13. A photo mask 14 is then applied over the catalyzed surface with photoformed openings defining a circuit pattern. The next step in the process comprises selective metal deposition of copper into the photoformed openings to provide conductors 15. Selective metal deposition is readily accomplished by immersion of the composite into an electroless copper plating solution whereby contact of the solution with the plating catalyst 13 results in deposition of copper to form conductors 15.

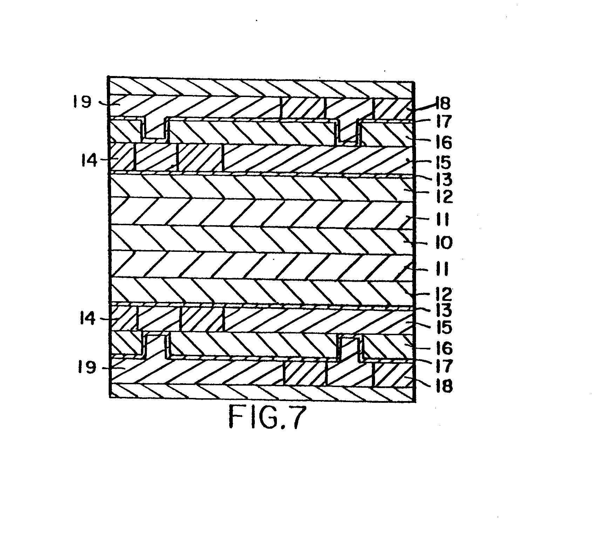

The next step in the process is the formation of conductive interconnections between copper conductors 15 and a subsequently applied signal layer. The results of this procedure are illustrated in Figure 7 of the drawings. A photo dielectric layer 16 with photoformed openings is applied over the surface comprising conductors 15 and photo mask 14 and this layer is catalyzed with a layer of plating catalyst 17. Thereafter, a layer of a photo mask is applied over the catalyst layer 17 to mask those areas where plating is not desired and to define a signal layer. The composite is then immersed in an electroless plating solution whereby electroless copper deposits on the walls of the photoformed openings to provide copper interconnects and conductors 19. If the composite is left in the plating solution for a sufficient period of time, the photoformed openings will fill with the copper whereby a solid peg of copper comprises the conductive interconnection. Plating is preferably continued until the deposit is to the full thickness of dielectric 16 and photo mask layer 17 as shown in the drawing.

If the stack formed by the above process is to be used as part of a more complex structure and lamination is required, the stack so formed is coated with an uncured liquid epoxy resin. The liquid resin will infiltrate the crevices in the surface of the stack thereby eliminating entrapped air. For handling, the coated stack is partially cured whereby the epoxy is suitable for handling. The stack may then be laminated to another stack with heat and pressure, typically at a temperature in excess of 150°C.

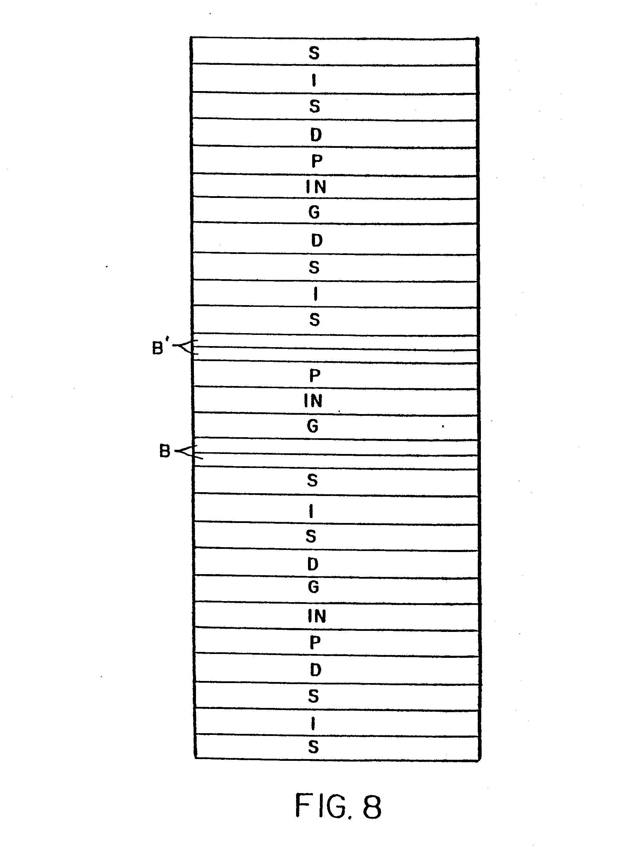

A lamination procedure as described above is illustrated in Figure 8 of the drawings. In Figure 8, the six-layer stack shown in Figure 7 is laminated to a similar six-layer stack through a dielectric substrate having a power and ground plane on its surfaces overcoated with a B-stage coating for adhesion. For simplification, letters are used to designate layers with the symbol S illustrating a signal layer, I illustrating an interconnect layer, P representing a power plane, D representing

- 17 -

0211180

an insulating dielectric layer, G representing a ground plane, B representing a B-stage resin used to adhere the stack together and In representing an innerlayer material.

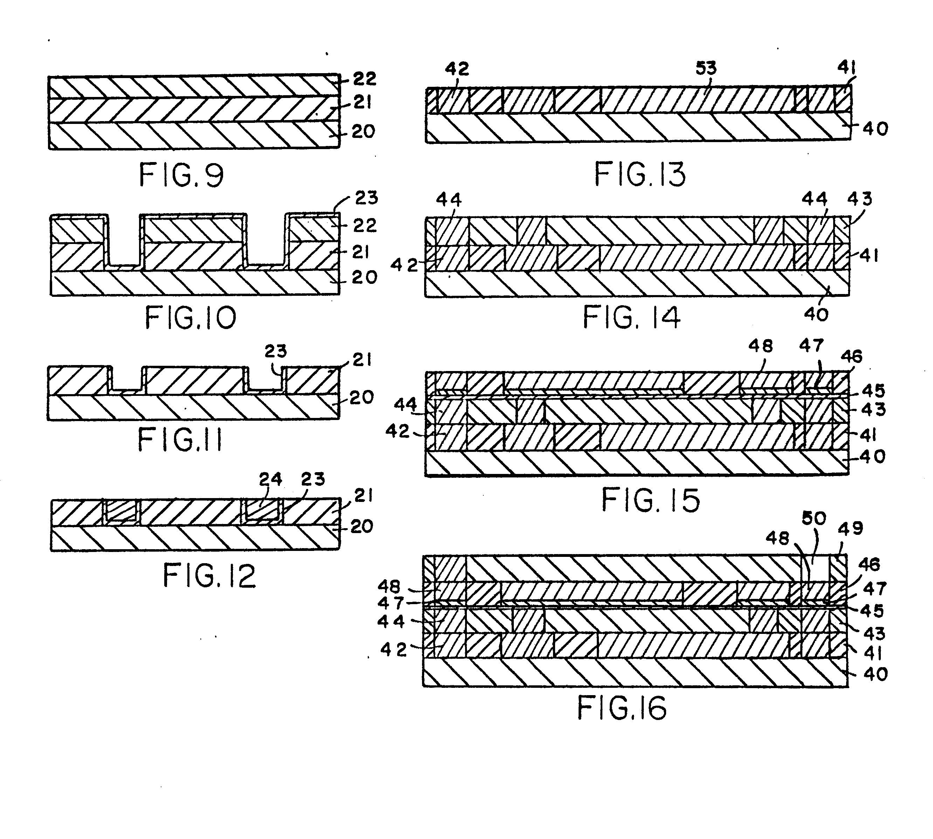

In the foregoing description, selective deposition of electroless metal is accomplished primarily by defining a masked image over a catalyzed surface. For purposes of the invention, it should be understood that other methods of selective deposition are possible. For example, a sacrificial resist layer may be utilized to form a selectively catalyzed surface. This embodiment of the invention is illustrated in Figures 9 through 12 of the drawings where the formation of a single-sided circuit is depicted in part.

In Figure 9, a carrier 20 is coated with a permanent photo mask 21. In Figure 10, the photo mask layer 21 is coated with a sacrificial layer 22. The sacrificial layer 22 and the photo mask layer 21 are imaged in a conductor pattern and developed to yield photoformed channels in both layers. The entire surface is then catalyzed to provide a layer of plating catalyst 23 over the surfaces of the photoformed channels and holes.

As shown in Figure 11, the photo mask layer 22 is then removed with a suitable solvent whereby there remains a layer of catalyst in a desired pattern. The exposed catalyst layer 23 may then be selectively plated to desired thickness with plating metal as shown in Figure 12. The circuit so formed may be completed in any manner desired such as that set forth above.

- 18 -

As a further alternative to the embodiments disclosed above, though a lesser preferred embodiment, the selective deposition can be achieved by admixing catalytic material directly with any of the dielectric coatings used in the process as illustrated in U.S. Patent No. 3,756,893 incorporated herein by reference where copper oxide is admixed in a resinous binder and then activated for plating.

The carrier does not have to become a part of the multilayer board. A temporary carrier can be used as illustrated in Figures 13 through 17 of the drawings wherein the formation of a stack having a conductive interconnection or peg running throughout the length of the multilayer stack is illustrated. With reference to Figure 13, a temporary carrier 40 comprising a stainless steel sheet platen is coated with a permanent photo mask 41 in a desired image pattern. Copper conductors 42 are then electroplated directly into the defined channels because the stainless steel platen 40 is a conductor as required for electroplating. As copper plates on the platen, it continues to build to desired thickness.

The next step in the process is shown in Figure 14. A photo dielectric layer 43 is applied over the surface comprising photo mask 41 and copper conductors 42. Photo dielectric layer 43 has photoformed openings defining interconnections. These openings may be electroplated with copper to full thickness of layer 43,

- 19 -

if desired to form solid pegs 44 that serve as interconnections. Direct electroplating is again possible because in this embodiment, stainless steel platen 40 provides conductivity to the holes through conductors 42 and the holes are not electrically isolated from conductors 42. If the holes had been electrically isolated, an alternative method for metal plating could comprise activating the copper conductors with an activator solution such as palladium chloride followed by plating copper by electroless deposition using a conventional electroless depositing solution.

Figure 15 illustrates the next steps in the process. A layer of catalyst 45 is applied over the surface consisting of photo dielectric coating 43 and copper interconnects 44. The catalytic layer is then overcoated with a layer of a photo mask 46 which defines conductor lines, interconnections, etc. An electroless layer of copper 47 may then be deposited over the plating catalyst layer 45 to full thickness, or, if desired and as illustrated in Figure 15, once a thin layer of copper is deposited, an electrolytic copper layer 48 may be plated over the thin layer of electroless copper 47 to full desired thickness. The electroless layer of copper was required in this embodiment of the invention because the signal lines 48 were not in contact with a conductive material over their entire width.

- 20 -

The above process can be repeated as often as desired. Figure 16 illustrates a continuation of the process where an additional layer of photo dielectric 49 is coated over the composite surface comprising photo mask 46 and signal lines 47. The photo dielectric layer 49 defines the interconnections. In this case, the interconnections are in electrical communication with the stainless steel platen. Consequently, interconnections 50 may be electroplated to full desired thickness.

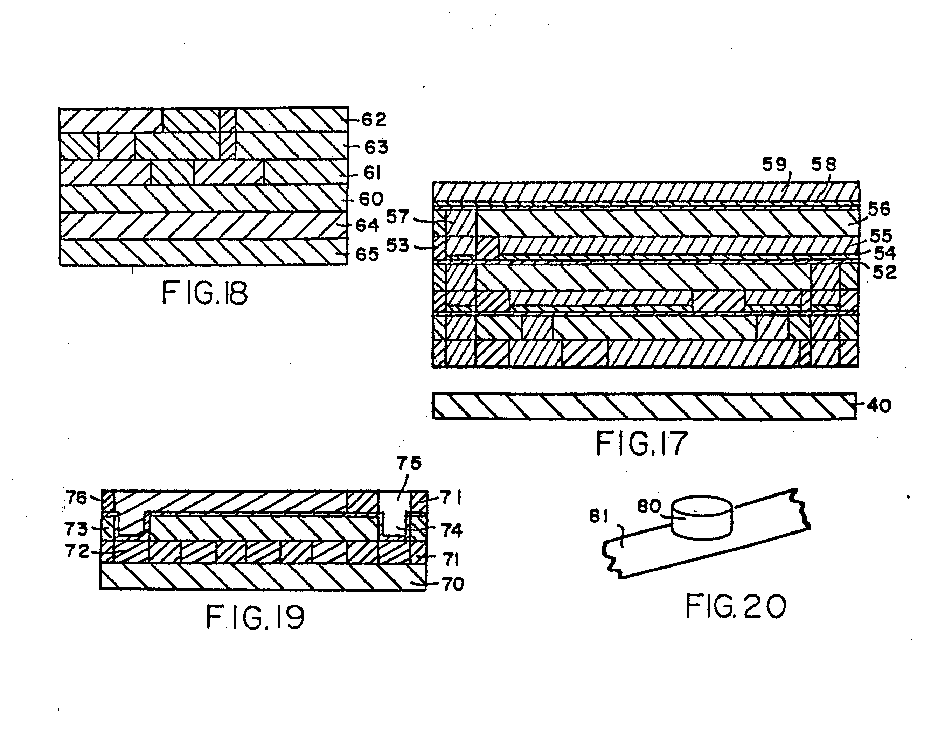

For multiple coatings, it is desirable to separate signal and interconnection layers with a ground plane, power plane combination. This can be accomplished by sequential coatings as illustrated in Figure 17. The surface comprising interconnections 50 and photo dielectric layer 49 is coated with plating catalyst 52. A photo mask layer 53 is applied in an image pattern. A thin layer of electroless copper 54 is formed over plating catalyst 52 and this is overcoated with electrolytic copper 55 to form a power plane with an insulated interconnect passing through the power plane. Another interconnect layer comprising photo dielectric 56 is formed together with an electroplated interconnect 57. The surface comprising photo dielectric layer 56 and interconnect 57 is catalyzed, a thin layer of electroless copper 58 is deposited over the catalyst and an electrolytic copper layer 59 is deposited to form a ground plane.

- 21 -

Finally, as shown in Figure 17, following formation of a desired stack, the platen 40 is removed as it served as a temporary carrier and source of conductivity, but was not intended to become part of the multilayer stack.

As described above, a complete multilayer board may be formed by sequential layering using the process of the invention. Alternatively, a stack comprising a portion of a multilayer board may be formed and laminated to another similar stack or a stack formed by procedures of the prior art. Regardless of how the final stack is formed, the process of the invention significantly simplifies the process of making printed circuits compared with prior art procedures.

Figure 18 illustrates an embodiment of the invention where a circuit is formed on one surface of a substrate and a multilayered EMI deposit is formed on the other surface. As shown in the drawing, a substrate 60, which in this embodiment of the invention could comprise a housing for electronic equipment, has two layers of signal lines 61 and 62 joined by a layer of metalized interconnections 63 on one surface of substrate 60 and a layer of copper 64 overcoated with a layer of nickel 65 on its other surface. The layer of copper and nickel is preferably an electroless deposit and, as is known in the art, is capable of functioning to prevent EMI radiation from the electronic component.

- 22 -

An application of the invention is illustrated in Figure 19 of the drawings which represents a multi-chip substrate for micro computer use. In this embodiment of the invention, there is shown a small module with several signal layers having fine conductor and via sizes in permanent dielectric layers. The module comprises substrate 70 having photo mask layer 71 in a grid type array of vias and conductors 72. An electroless plating catalyst (not shown) would be present between the substrate and the layer of photo mask 71 and deposited copper 72. This layer is overcoated with a layer of photo dielectric 73 with interconnects 74 passing therethrough. The next layer, which completes this embodiment of the invention, comprises conductors 75 bounded by photo mask layer 76.

The embodiment of the invention represented in Figure 19 is characterized by conductors and vias of extremely small dimension. Because the layers are formed using photo active materials with high resolution capability and good dielectric properties, vias and conductor lines can be formed with widths of from about 1 to 10 mils with the vias spaced from about 1 to 50 mils on center. Dependent on the resolution capabilities of the photo dielectric used, it would be possible to have more than 100 lines and spaces per linear inch and in some instances, greater than 400 lines and spaces. This permits the formation of a multilayer module with extreme densification believed to be heretofore unavailable in the art.

- 23 -

As described above, the photoformed openings may be of any desired shape or size. In this respect, the invention described herein permits formation of through-hole interconnects that could not be achieved with prior art processes. For example, as shown in Figure 20, an interconnect 80 can be placed directly within the confines of a conductor 81 without degradation of the current carrying capacity of the interconnect because of its elliptical shape.

The procedures described above in reference to the drawings illustrate the major steps in the process contemplated by the invention. It should however be obvious that many of the procedural steps known in the art have been omitted. For example, it is known in the art that when using organic coating materials, baking for drying and curing are recommended and art recognized procedures. Likewise, to adhere one organic coating to another, it is often necessary to pretreat the coating to enhance adhesion. In catalysis processes, it is conventional to treat the catalyst with an accelerator prior to plating. To prepare copper for subsequent deposition or for adhesion of an organic coating material to it, it is often necessary to clean and activate the copper. These are all steps known to the art and not described in detail herein.

The photo mask and photo dielectric used in the processes of the invention should have an adequate dielectric constant so as

- 24 -

to adequately electrically insulate conductors from each other. In this respect, a dielectric constant of not greater than 4.5 is preferred and a dielectric constant not exceeding 3.5 is more preferred.

In addition to the above, the photo mask and photo dielectric should be capable of yielding images of satisfactory resolution. The necessary resolution is dependent upon the requirements of the multilayer board. Preferably, the resolution should be sufficient to provide line widths not exceeding 10 mils, preferably not exceeding 5 mils, and most preferably, not exceeding 2 mils. The interconnection openings desirably do not exceed 5 mils and preferably are of a diameter less than the line width of the signal lines.

The photo mask and photo dielectric should also be resistant to attack by an electroless plating solution over periods of prolonged exposure. Electroless copper plating solutions are usually strongly alkaline. Therefore, the plating resist should be resistant to attack by alkaline solutions. Where the mask is to be photo imaged, it should be capable of clean development. Materials suitable for this purpose are disclosed in U.S. Patent No. 4,439,517 incorporated herein by reference.

The coating composition can be applied in any manner known to those skilled in the art. For example, they may be applied as a liquid coating composition and dried. Alternatively, they may

be applied as a preformed dry film for thickness control. Further, they may be applied as a preformed multilayer film. Once coated and dried (if applied as a liquid coating composition), the composition is irradiated by exposure to actinic radiation of suitable wavelength such as a wavelength from 200 to 600 nm for the above formulation. Mercury vapor arcs are particularly useful for exposure. Following exposure, the exposed photosensitive plating resist is heat cured at a temperature of from 100 to 140° centigrade for from 2 to 25 minutes. The part is developed by dissolving the uncured portions of the resist with a solvent such as cyclohexanone, 2-ethoxyethanol, toluene, acetone, etc.

Though the invention has been described using the example set forth above, it should be understood that the invention is useful for many other methods for the manufacture of multilayer boards.

- 26 -

## CLAIMS

1. A process for the formation of a circuit board having two or more layers of circuitry, said process comprising the steps of applying a permanent dielectric coating over a first circuit layer, said coating having photoformed recesses defining interconnections between circuit layers, applying a permanent mask layer over said dielectric coating, said mask having recesses defining conductor lines and interconnections, and selectively depositing metal within the recesses defining conductor lines and interconnections to render the same conductive, whereby a second curcuit layer is formed over the photo dielectric coating layer and the conductors of said first and second circuit layers are in electrical communication with each other through conductive interconnections.

2. The process of claim 1 where said process is performed on a carrier.

3. The process of claim 2 where the carrier is said first circuit layer which becomes a permanent part of the circuit board.

4. The process of claim 1 where the selective deposition of metal is electrolessly deposited copper.

5. The process of claim 1 where the selective deposition of metal is electrolytically deposited copper.

6. The process of claim 1 where at least one of said circuit layers is formed by applying a permanent photo mask layer over a surface, said photo mask having photoformed openings therein defining conductor lines and interconnection openings, and selectively depositing metal within said defined conductor lines and openings to render the same conductive.

7. The process of claim 6 where the openings in said photo mask contain the deposited metal.

8. The process of claim 6 where both circuits are formed by applying a permanent photo mask over a surface and selectively depositing metal within openings to render the same conductive.

9. The process of claim 6 including the steps of sequentially repeating the process of forming interconnection and circuit layers until the desired number of layers are formed.

10. The process of claim 9 including the step of separating multiple layers of circuits and interconnections with an innerlayer material having a ground and/or power plane on its surfaces.

11. The process of claim 9 including the step of laminating one or more stacks of multiple layers of circuits and interconnections to additional stacks of multiple layers of circuits and interconnections.

12. The process of claim 11 where the stacks are laminated using an uncured, liquid resin.

13. The process of claim 6 where the permanent dielectric layer and the permanent photo mask layer are photoimagable and openings are photoformed by exposure to activating radiation in an image pattern and developing the imaged coating.

14. The process of claim 6 where selective metalization is accomplished by catalyzing with an electroless plating catalyst, masking catalyzed areas where plating is not desired with a plating mask and plating electroless metal over the electroless plating catalyst not covered with the plating mask.

15. The process of claim 14 where the plating mask is the photo mask.

16. The process of claim 14 where the electroless plating catalyst is a palladium catalyst.

17. The process of claim 15 where the electroless metal is plated to a thickness essentially equivalent to the thickness of the mask whereby the surface of the circuit is essentially planar.

18. The process of claim 6 where selective metalization is accomplished by applying a sacrificial coating over a layer of photoformed openings, said sacrificial coating having openings corresponding to the openings in said layer, catalyzing the sacrificial coating and the openings with an electroless plating catalyst, removing the sacrificial coating and plating electroless metal over the electroless plating catalyst within the photoformed openings.

- 29 -

19. The process of claim 18 where the electroless plating catalyst is a palladium catalyst.

20. The process of claim 17 where the layer is selected from the group of the photo mask and the photo dielectric.

21. The process of claim 20 where the openings in said layer contain the deposited metal.

22. The process of claim 20 where the electroless metal is plated to a thickness essentially the same as the thickness of the layer whereby the surface is essentially planar.

23. The process of claim 6 including the step of admixing a plating catalyst with a layer having photoformed openings, coating said layer with a plating mask where plating is not desired and plating electroless metal over the layer not covered with the plating mask.

24. The process of claim 6 where selective metalization is accomplished by catalyzing with an electroless plating catalyst, stripping the catalyst where plating is not desired and plating electroless metal over the remaining electroless plating catalyst

25. The process of claim 2 where the carrier is a conductive platen.

26. The process of claim 25 where selective metalization is accomplished by electrolytic deposition with the platen serving as a source of current for said deposition.

- 30 -

27. The process of claim 6 where selective metalization is accomplished by electroless deposition of metal over a copper that has been activated with a solution of dissolved palladium ions.

28. The process of claim 6 where interconnections have a maximum width not exceeding 10 mils.

29. The process of claim 6 where conductor lines of a circuit within a photoformed opening have a maximum width not exceeding 5 mils.

30. The process of claim 6 where conductor lines of a circuit within a photoformed opening have a maximum width not exceeding 2 mils.

31. The process of claim 6 where the interconnects lie within a conductor line.

32. The process of claim 6 where the interconnections are pegs of solid copper.

33. The process of claim 6 where the interconnections have plated walls.

34. The process of claim 6 where the carrier is a permanent part of the circuit board.

35. The process of claim 34 where the carrier is a molded circuit board.

36. The process of claim 34 where the carrier is a hybrid circuit.

37. The process of claim 34 where the carrier is an innerlayer material.

38. The process of claim 37 where the carrier is an innerlayer material having a power or ground plane over one or both of its surfaces.

39. The process of claim 6 where the process is applied to both sides of a carrier.

40. The process of claim 39 where the circuits on each side of the carrier are connected by conductive holes.

41. A multilayer circuit board having at least two layers of circuitry where the circuits are separated from each other by a permanent photo dielectric layer having photoformed metalized openings providing electrical communication between said circuits.

42. The board of claim 41 where one of the circuit layers is a carrier that is a permanent part of the multilayer circuit board.

43. The board of claim 41 where the metal of the metalized openings is electrolessly deposited copper.

44. The board of claim 43 where the metal of the metalized openings is electrolytically deposited copper.

45. The board of claim 41 where at least one of said circuits comprises a photo mask having photoformed openings therein defining conductor lines and interconnection openings having metal deposited within said photoformed openings.

- 32 -

46. The board of claim 45 where the openings in said photo mask contain the deposited metal.

47. The board of claim 41 comprising multiple layers of circuits separated from each other by multiple layers of a permanent photo dielectric layer having photoformed metalized openings providing electrical communication between circuits on one or both sides of a carrier.

48. The board of claim 47 including innerlayers having a ground and/or power plane on its surfaces placed between circuit layers.

49. A multilayer stack comprising boards of claim 48 laminated to each other.

50. The multilayer stack of claim 49 where each board is a composite of four or more layers comprising a carrier that is a two-sided innerlayer with power and ground planes on its surfaces and having at least two layers of circuitry connected through conductive interconnections.

51. The multilayer stack of claim 49 where each board is a composite of six or more layers comprising a carrier that is a two sided innerlayer with power and ground planes on its surfaces and having at least two layers of circuitry connected through conductive interconnections on each surface, said circuits on each side of the innerlayer being in electrical communication with each other through plated interconnections.

- 33 -

52. The board of claim 42 where the deposited metal is of a thickness essentially equivalent to the thickness of the mask whereby the surface of the circuit is essentially planar.

53. The board of claim 41 where interconnections have a maximum width not exceeding 10 mils.

54. The board of claim 53 where the width does not exceed 2 mils.

55. The board of claim 45 where conductor lines of a circuit within a photoformed opening have a maximum width not exceeding the conductor line in which it is in contact.

56. The board of claim 41 where the interconnections are pegs of solid copper.

57. The board of claim 41 where the carrier is a permanent part of the circuit board.

58. The board of claim 41 having circuits and interconnections on both sides of the carrier.

59. The board of claim 58 where the circuits on each side of the carrier are connected by conductive holes.

60. The board of claim 41 where the openings are circular.

61. The board of claim 41 where the openings are non-circular.

62. The board of claim 41 where there are greater than 100 lines and spaces per linear inch of board.

63. The board of claim 62 where there are greater than 400 lines and spaces per linear inch.

64. An electrical assembly comprising at least two conductor lines in electrical communication with each other through a metallic connection contained within a photo dielectric material.

65. The assembly of claim 64 where the metallic connection is a solid peg.

FIG.5

FIG.6

FIG.1

FIG.2

FIG.3

FIG.4

FIG.7

FIG. 8

FIG.13

FIG.14

FIG.15

FIG.16

FIG.9

FIG.10

FIG.11

FIG.12

FIG.18

FIG.17

FIG.19

FIG.20